Europäisches Patentamt

**European Patent Office**

Office européen des brevets

(19)

(11) Numéro de publication: **0 102 257**
**B1**

(12) **FASCICULE DE BREVET EUROPEEN**

(45) Date de publication du fascicule du brevet: 03.02.88

(51) Int. Cl.⁴: **G 11 C 19/08**

(21) Numéro de dépôt: 83401309.6

(22) Date de dépôt: 23.06.83

(54) **Mémoire à bulles magnétiques à motifs non implantés et son application à la duplication par élément binaire et par bloc d'éléments binaires.**

(30) Priorité: 29.06.82 FR 8211407

(43) Date de publication de la demande:
07.03.84 Bulletin 84/10

(45) Mention de la délivrance du brevet:
03.02.88 Bulletin 88/05

(84) Etats contractants désignés:
DE GB NL

(56) Documents cités:
EP-A-0 011 137
EP-A-0 030 150
US-A-4 128 895

IBM TECHNICAL DISCLOSURE BULLETIN, vol. 17, no. 11, avril 1975, NEW YORK (US) L.T. ROMANKIW et al.: "Immiscible liquid magnetic and non magnetic (Ferrofluid) bubble display with magnetic bubble propagation and recirculator", pages 3474-3477

(73) Titulaire: **COMMISSARIAT A L'ENERGIE ATOMIQUE**
**31/33, rue de la Fédération**
**F-75015 Paris (FR)**

(72) Inventeur: **Jouve, Hubert**
**8, Domaine des Plantées**
**F-38330 Biviers (FR)**
Inventeur: **Magnin, Joel**
**3, rue Doyen Gosse**
**F-38400 Saint Martin D'Heres (FR)**

(74) Mandataire: **Mongrédien, André et al**
**c/o BREVATOME 25, rue de Ponthieu**
**F-75008 Paris (FR)**

(56) Documents cités:
THE BELL SYSTEM TECHNICAL JOURNAL, vol. 59, no. 2, février 1980, NEW YORK (US) T.J. NELSON et al.: "Design of bubble device elements employing ion-implanted propagation patterns", pages 229-257

Courier Press, Leamington Spa, England.

**Description**

La présente invention a pour objet une mémoire à bulles magnétiques à motifs non implantés. Elle s'applique notamment à la mémorisation d'informations binaires ou bits, matérialisés sous la forme de domaines magnétiques isolés, qualifiés de bulles; ces domaines généralement cylindriques, présentent une aimantation inverse de celle du reste du matériau magnétique (grenat) constituant la couche dans laquelle ces domaines sont formés. Dans cette mémoire, la duplication de bulles magnétiques permet notamment d'effectuer la duplication d'élément binaire par élément binaire ou la duplication par bloc d'éléments binaires.

Dans une couche magnétique monocristalline telle qu'un film de grenat magnétique, supporté par un grenat monocristallin amagnétique, les domaines ou bulles magnétiques sont stables par application d'un champ magnétique continu Hp perpendiculaire au plan de la couche magnétique. Dans la pratique, ce champ magnétique est créé par un aimant permanent assurant ainsi la non volatilité des informations contenues dans la mémoire.

Dans une mémoire à bulles magnétiques, le déplacement des bulles est réalisé en appliquant un champ continu tournant $H_T$ suivant une direction parallèle à la surface de la couche magnétique. Le déplacement des bulles se fait autour de motifs dits de propagation, définis dans la partie supérieure de la couche magnétique.

Ces motifs présentent la forme de disques, de losanges, de triangles, de T etc. peuvent être réalisés en un matériau à base de fer et de nickel, ou bien obtenus en implantant des ions dans la partie supérieure de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contigus; du fait de leur forme, deux motifs adjacents délimitent entre eux deux cavités ou creux.

Le déplacement des bulles le long de ces motifs se fait généralement pendant une durée égale au tiers de la période de rotation du champ magnétique $H_T$ plan, les bulles restant immobiles dans les cavités définies entre deux motifs adjacents, pendant le reste du cycle. On réalise ainsi des registres à décalage dans lesquels l'information binaire "1" est représentée par la présence d'une bulle et l'information binaire "0" par l'absence d'une bulle.

En plan de ces motifs de propagation, il est nécessaire d'utiliser des conducteurs électriques pour réaliser dans la mémoire à bulles, des fonctions d'écriture, d'enregistrement de l'information, de lecture non destructive, de transfert de registre à registre et d'effacement.

Un des principaux types de mémoire à bulles magnétiques connu comprend un ensemble de boucles, ou registres, dites mineures servant au stockage des informations, associé à une ou deux boucles, ou registres, dites majeures, constituant les stations d'accès à la mémoire. Les boucles mineures sont disposées longitudinalement, les unes à côté des autres et les boucles majeures sont orientées perpendiculairement aux boucles mineures. Les bulles magnétiques se trouvant dans les boucles mineures peuvent être transférées dans les boucles majeures et réciproquement, par l'intermédiaire de portes de transfert unidirectionnelles ou bidirectionnelles.

Lorsque l'on utilise une seule boucle majeure la lecture et l'écriture des informations se font au moyen de cette unique boucle. Dans ce premier cas, on parle d'une mémoire présentant une organisation majeure-mineure. En revanche, lorsque l'on utilise deux boucles majeures, l'écriture des informations se fait par l'intermédiaire de l'une de ces deux boucles et la lecture des informations par l'intermédiaire de l'autre boucle. Ces boucles majeures sont généralement situées de part et d'autre des boucles mineures. Dans ce dernier cas (deux boucles), on parle généralement d'une mémoire présentant une organisation série-parallèle.

Dans les mémoires à bulles décrites ci-dessus, la fabrication d'une bulle sur une boucle majeure, correspondant à l'écriture d'une information, est réalisée en appliquant un courant élevé à un conducteur, généralement en forme de U, traversant les motifs de propagation constituant la boucle majeure. Cette opération généralement connue sous le nom de nucléation est réalisée lorsque la bulle est dans une cavité définie entre deux motifs adjacents.

Après nucléation, la bulle est ensuite propagée, par application du champ tournant $H_T$, sur la boucle majeure vers les portes de transfert afin de transférer la bulle de la boucle majeure vers une boucle mineure. Ces portes de transfert sont généralement réalisées par un conducteur en forme de U traversant les motifs constituant la boucle mineure. L'application d'une impulsion de courant à ce conducteur permet d'étendre chaque bulle entre les sommets des motifs de propagation de la boucle majeure et ceux correspondants de la boucle mineure et ensuite, l'arrêt de l'impulsion de courant entraîne la contraction des bulles sur la boucle mineure. Le transfert est alors réalisé. L'information est ainsi stockée sur la boucle mineure.

La lecture de cette information se fait en transférant une bulle magnétique d'une boucle mineure vers une boucle majeure. Le transfert se fait comme précédemment.

Pour effectuer la lecture d'une information de manière non destructice, la bulle correspondante doit être dupliquée. Dans le cas d'une duplication bulle par bulle, cette duplication est réalisée au moyen d'un conducteur traversant la boucle majeure auquel on applique une impulsion de courant, entraînant l'élongation de la bulle de part et d'autre des chemins de propagation puis la coupure de cette bulle en deux. L'une de ces bulles, transférée sur un chemin de détection, pourra être détectée de façon destructive par un détecteur magnétorésistif, généralement à base de fer et de nickel, et l'autre bulle sera ré-injectée dans la boucle mineure à la place occupée par la bulle d'origine.

Une mémoire à bulles fonctionnant sur ce principe a été décrite dans un brevet américain n° 4 253 159, déposé le 3 décembre 1979 et intitulé "Ion-implanted bubble memory with replicate port". Dans ce brevet, on utilise une seule boucle majeure et des motifs de propagation non implantés.

Comme autres documents décrivant des mémoires à bulles à motifs non implantés, on peut citer le document EP—A—0 011 137 et le document The Bell System Technical Journal, vol. 59, n° 2, février 1980, New York (US) T. J. Nelson et al. pages 229—257, "Design of bubble device elements employing ion-implanted propagation patterns".

Les mémoires à bulles magnétiques comportant comme motifs de propagation des motifs non implantés et présentant une structure et un fonctionnement tels que ceux décrits précédemments, (voir brevet américain), ne permettent d'effectuer qu'une duplication des bulles correspondant à une duplication d'élément binaire par élément binaire. Ces mémoires ne permettent pas d'effectuer la duplication d'un ensemble ou bloc d'éléments binaires.

La présente invention a justement pour objet une mémoire à bulles magnétiques à motifs non implantés permettant de remédier à cet inconvénient.

De façon plus précise, l'invention a pour objet une mémoire à bulles magnétiques comportant une première couche de matériau magnétique monocristallin présentant au moins un axe cristallographique ayant la propriété d'être un axe plan de facile aimantation, des ensembles de motifs non implantés, contigus et alignés, dit premiers motifs, formés dans la première couche et permettant la propagation des bulles dans une seconde couche magnétique, située en dessous de la première couche magnétique, ces premiers motifs possédant une forme telle que deux cavités sont délimitées entre deux premiers motifs adjacents, chaque ensemble de premiers motifs présentant un axe tel que les premiers motifs dudit ensemble sont disposés symétriquement par rapport à cet axe, un conducteur électrique, dit premier conducteur associé à chaque ensemble et traversant ledit ensemble, et des moyens pour appliquer parallèlement à la seconde couche un champ magnétique tournant présentant une période de rotation donnée, caractérisée en ce que, les ensembles de motifs sont disposés parallèlement à l'axe cristallographique de la première couche, chaque premier conducteur est disposé perpendiculairement à l'axe cristallographique de ladite première couche, les deux premiers motifs adjacents d'un même ensemble, situés à l'endroit où est disposé le premier conducteur associé, présentant chacun une région implantée, ces régions étant situées symétriquement par rapport audit premier conducteur et symétriquement par rapport à l'axe de cet ensemble de premiers motifs, et en ce qu'elle comprend des moyens pour appliquer sur chaque premier conducteur au moins une impulsion de courant, entraînant une duplication de la bulle logée dans l'une des cavités délimitées entre les deux premiers motifs adjacents situés au niveau de ce premier conducteur, cette duplication consistant en un allongement de la bulle de part et d'autre de l'ensemble de motifs associé à ce premier conducteur et en une coupure de cette bulle en deux, et des moyens pour arrêter l'alimentation en courant de ce premier conducteur lorsque le champ magnétique est parallèle à l'axe de l'ensemble de motifs associé.

De préférence, les premiers motifs présentent des formes et des dimensions identiques.

L'utilisation de motifs de propagation non implantés, disposés de manière symétrique par rapport à un axe et parallèlement à l'un des axes cristallographiques de la couche de matériau contenant ces motifs, permet d'obtenir deux chemins de propagation, de part et d'autre de ces motifs, rigoureusement équivalents. En particulier, ces deux chemins de propagation présentent des propriétés magnétiques identiques et des puits de potentiel égaux, vis-à-vis de la propagation des bulles.

De plus, la position relative des motifs non implantés et des conducteurs servant à la duplication permet une duplication aisée des bulles magnétiques.

L'utilisation de régions implantées à l'endroit où est disposé le premier conducteur facilite, lors de la duplication, la traversée des bulles (elongation de part et d'autre de l'ensemble de motifs), ainsi que la coupure en deux de celles-ci.

De préférence, chaque premier conducteur électrique présente un axe de symétrie et est disposé de façon que cet axe de symétrie passe par les deux cavités délimitées par deux premiers motifs adjacents de l'ensemble qui lui est associé et au niveau de la région la plus profonde de ces cavités.

Afin de permettre la propagation et la duplication de bulles magnétiques présentant un diamètre de 2 µm environ, la distance séparant les régions les plus profondes des deux cavités, délimitées entre deux premiers motifs adjacents d'un même ensemble, sera, de préférence, comprise entre 2 et 20 µm.

La structure telle que décrite précédemment peut être avantageusement utilisée dans une mémoire à bulles présentant une organisation majeure-mineure.

Selon un mode préféré de réalisation de l'invention, cette mémoire à bulles comportant des boucles mineures servant au stockage des bulles, disposées les unes à côté des autres et comportant chacune deux extrémités, ces boucles mineures étant formées de motifs de propagation non implantés contigus, dits seconds motifs, au moins une boucle majeure servant de boucle d'accès aux boucles mineures, disposée perpendiculairement aux boucles mineures, cette boucle majeure étant formée de motifs de propagation non implantée contigus, dits troisièmes motifs, et des moyens pour détecter et engendrer des bulles sur la boucle majeure, se caractérise en ce que chaque boucle mineure est repliée de façon qu'elle définisse, à l'une de ses extrémités, deux morceaux distincts situés l'un à côté de l'autre, le premier morceau servant à l'injection de bulles dans cette boucle mineure et le second morceau à l'extraction de bulles de cette boucle mineure, et en ce que chaque boucle mineure est associée à un ensemble de premiers motifs, servant au transfert des bulles de la boucle mineure correspondante vers la boucle majeure, et réciproquement, ces ensembles de premiers motifs comportant à l'une de leurs extrémités deux embranchements distincts, un premier embranchement servant à l'injection de bulles dans la boucle mineure correspondante et un second embranchement servant à l'extraction de bulles de la boucle mineure correspondante, lesdits embranchements, formés de motifs de propagation non implantés, contigus et alignés, dits quatrièmes motifs, étant situés l'un à côté de l'autre de façon que l'extrémité du premier embranchement soit en regard de l'extrémité du premier morceau de la boucle mineure correspondante et que l'extrémité du second embranchement soit en regard de l'extrémité du second morceau de la boucle mineure correspondante, l'extrémité du second embranchement étant munie d'une porte de transfert unidirectionnelle pour assurer le transfert des bulles de la boucle mineure vers l'ensemble de motifs associé.

Selon un autre mode préféré de réalisation de cette mémoire à bulles, le quatrième motif d'extrémité dudit premier embranchement et le second motif d'extrémité dudit premier morceau de la boucle mineure, situés en regard l'un de l'autre, sont alignés, cet alignement formant un angle voisin de 30° avec l'axe cristallographique de la première couche magnétique.

Selon un autre mode préféré de réalisation de cette mémoire à bulles, les ensembles des premiers motifs comportant à leur autre extrémité une porte de transfert bidirectionnelle pour assurer le transfert des bulles de la boucle majeure vers ces ensembles de motifs, et réciproquement.

Dans le cas d'une mémoire à bulles à organisation série-parallèle, cette mémoire, comportant deux boucles majeures, la première étant en regard des moyens de détection des bulles et la seconde en regard des moyens permettant d'engendrer les bulles, est telle que, selon un mode préféré de réalisation de l'invention, les ensembles de premiers motifs sont accolés, au niveau de leur autre extrémité, à la première boucle majeure, cette boucle majeure comportant des ouvertures, pratiquées dans les troisièmes motifs non implantés la constituant, permettant le transfert des bulles de l'ensemble de premiers motifs vers cette boucle majeure, et telle que l'autre extrémité des boucles mineures comporte une porte de transfert permettant le transfert des bulles de ces boucles mineures à la deuxième boucle majeure, et réciproquement.

Un mode préféré de réalisation de l'invention a aussi pour objet de nouveaux moyens permettant d'engendrer les bulles magnétiques dans une mémoire à bulles. Ces moyens comprennent un ensemble de motifs de propagation non implantés contigus, dits cinquièmes motifs, possédant une forme telle que deux cavités sont délimitées entre deux motifs adjacents, une partie de ces motifs étant disposée de façon à former une boucle fermée, l'autre partie constituant un chemin de propagation pour les bulles engendrées et un conducteur électrique, dit second conducteur, permettant la duplication de bulles disposé perpendiculairement à l'axe cristallographique de la première couche magnétique, ledit ensemble de cinquièmes motifs étant traversé par ce second conducteur, au niveau de la partie en forme de boucle fermée. De préférence, ces cinquièmes motifs présentent des formes et des dimensions identiques.

Ces moyens permettent avantageusement de remplacer les générateurs à bulles classiques fonctionnant sur le principe de la nucléation.

Selon un mode préféré de réalisation de ces moyens, la première couche magnétique présente trois axes cristallographiques, la boucle fermée possède la symétrie d'ordre trois de cette couche magnétique.

Selon un autre mode préféré de réalisation de ces moyens, le second conducteur électrique présente un axe de symétrie et est disposé de façon que son axe de symétrie passe par les deux cavités délimitées par deux cinquièmes motifs adjacents et au niveau de la région la plus profonde de ces cavités.

Selon un autre mode préféré de réalisation de ces moyens, les cinquièmes motifs adjacents, situés à l'endroit du second conducteur électrique, présentent chacun une région implantée, ces régions étant disposées symétriquement par rapport à l'axe de symétrie du second conducteur.

La mémoire selon l'invention peut être avantageusement utilisé pour effectuer soit la duplication d'éléments binaires, élément binaire par élément binaire, la duplication étant réalisée en alimentant les conducteurs électriques servant à la duplication par des impulsions successives de courant soit, la duplication par bloc d'éléments binaires. Il est à noter qu'une duplication par bloc d'éléments binaires, dans une mémoire à bulles magnétiques comportant des motifs de propagation non implantés n'était alors pas réalisable avec les mémoires à bulles de l'art antérieur.

D'autres caractéristiques et avantages de l'invention ressortiront mieux de la description qui suit, donnée à titre illustratif et nullement limitatif en référence aux figures annexées, sur lesquelles:

la figure 1 représente schématiquement une partie d'une mémoire à bulles, selon l'invention, illustrant la disposition respective des motifs non implantés de cette mémoire par rapport au conducteur électrique de duplication,

la figure 2 représente un agrandissement de la figure 1 au niveau de la traversée des motifs de propagation par le conducteur électrique,

la figure 3 représente schématiquement une mémoire à bulles, conformément à l'invention, comportant plusieurs boucles mineures associées à une unique boucle majeure,

la figure 4 représente schématiquement une mémoire à bulles, conformément à l'invention, présentant une organisation série-parallèle; et

la figure 5 représente schématiquement les moyens permettant d'engendrer les bulles dans une mémoire, conformément à l'invention.

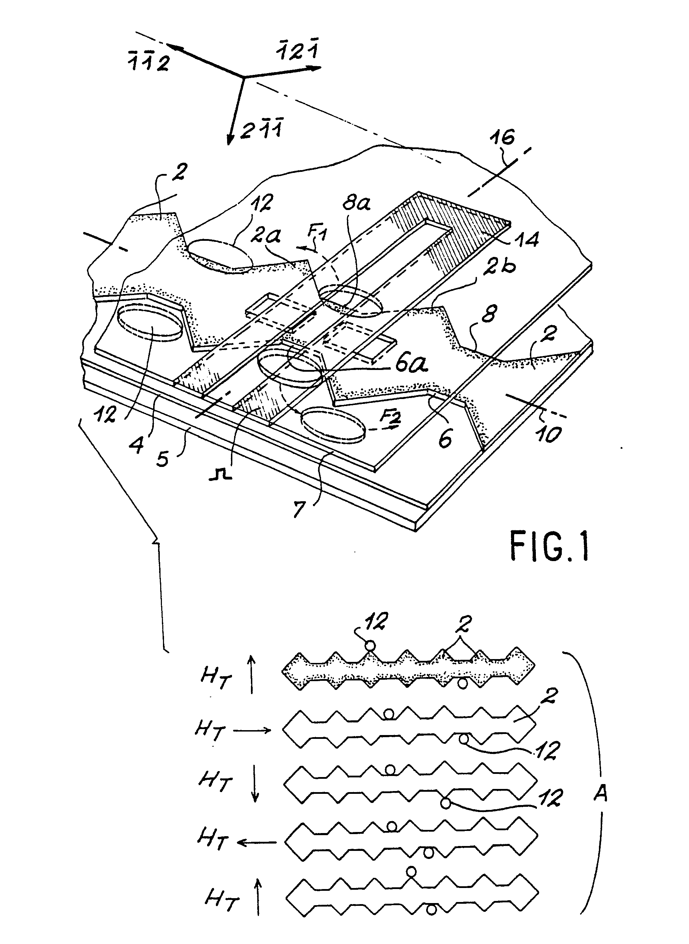

Sur la figure 1, on a représenté une partie d'une mémoire à bulles selon l'invention. Cette partie de mémoire comprend un ensemble de motifs de propagation non implantés 2, disposés les une à côté des autres et alignés. Ces motifs de propagation 2 sont obtenus par implantation d'ions, à travers un masque, dans une couche de matériau magnétique 4 monocristallin. Cette couche de matériau 4, par exemple de grenat épitaxié suivant la direction 111, possède trois axes cristallographiques équivalents, de facile aimantation, respectivement $\overline{1}12$, $\overline{1}2\overline{1}$ et $2\overline{1}\overline{1}$, comme représenté en haut de la figure.

Les motifs de propagation 2 présentent une forme telle que deux cavités respectivement 6 et 8 soient délimitées entre deux motifs 2 adjacents. Ces motifs de propagation 2 peuvent présenter la forme de losanges, de triangles, de cercles, d'ellipses, de polygones, etc. Sur la figure 1, ces motifs présentent la forme de losanges. De préférence, ces motifs de propagation présentent des formes et des dimensions identiques.

Selon l'invention, les motifs 2 sont disposés symétriquement par rapport à un axe 10. Par ailleurs, l'ensemble de motifs de propagation 2 est disposé parallèlement à l'un des axes cristallographiques de la couche de matériau 4, dans laquelle sont réalisés ces motifs, comme par exemple l'axe cristallographique $\overline{1}12$. Cette disposition des motifs de propagation 2 permet d'obtenir deux chemins de propagation pour des bulles magnétiques telles que 12, situés de part et d'autre de l'ensemble de motifs, rigoureusement équivalents. Ces deux chemins de propagation sont représentés respectivement par les flèches $F_1$, $F_2$.

Les bulles magnétiques 12, situées dans une couche de matériau magnétique 5 (grenat) située en dessous de la couche de matériau 4 contenant les motifs 2 non implantés, peuvent être déplacées par application d'un champ magnétique $H_T$, continu et tournant, dirigé parallèlement à la couche de matériau 5. Sur la partie A de la figure 1, on a représenté le déplacement des bulles magnétiques 12 sous l'action du champ magnétique $H_T$. Comme représenté, le déplacement des bulles magnétiques se fait pendant une durée égale au tiers de la période de rotation du champ magnétique $H_T$.

En plus des motifs de propagation 2, la mémoire à bulles comprend un conducteur électrique 14 "traversant" l'ensemble de motifs de propagation. Dans la pratique, ce conducteur électrique est disposé sur une couche 7 située au-dessus de la couche de matériau 4 contenant les motifs de propagation 2, comme représenté sur la figure. Ce conducteur électrique 14, présentant par exemple un axe de symétrie 16, est disposé perpendiculairement à l'un des axes cristallographiques de la couche de matériau magnétique 4, par exemple l'axe cristallographique $\overline{1}12$.

De préférence, ce conducteur électrique 14, par exemple en forme de U, est disposé de façon que son axe de symétrie 16 passe par les deux cavités 6a, 8a délimitées par les deux motifs adjacents 2a et 2b, situés au niveau de ce conducteur, et au niveau de la région la plus profonde de ces cavités.

Ce conducteur électrique 14 est utilisé pour réaliser la duplication ou dédoublement des bulles magnétiques 12. Cette duplication est généralement effectuée pour aller lire les informations contenues dans la mémoire. La duplication des bulles magnétiques 12 est réalisée en alimentant le conducteur électrique 14 par au moins une impulsion de courant, comme représenté sur la figure. Selon l'invention, cette impulsion de courant doit être appliquée pour une phase bien déterminée du champ magnétique $H_T$, appliqué à la couche de matériau 5 contenant les bulles magnétiques.

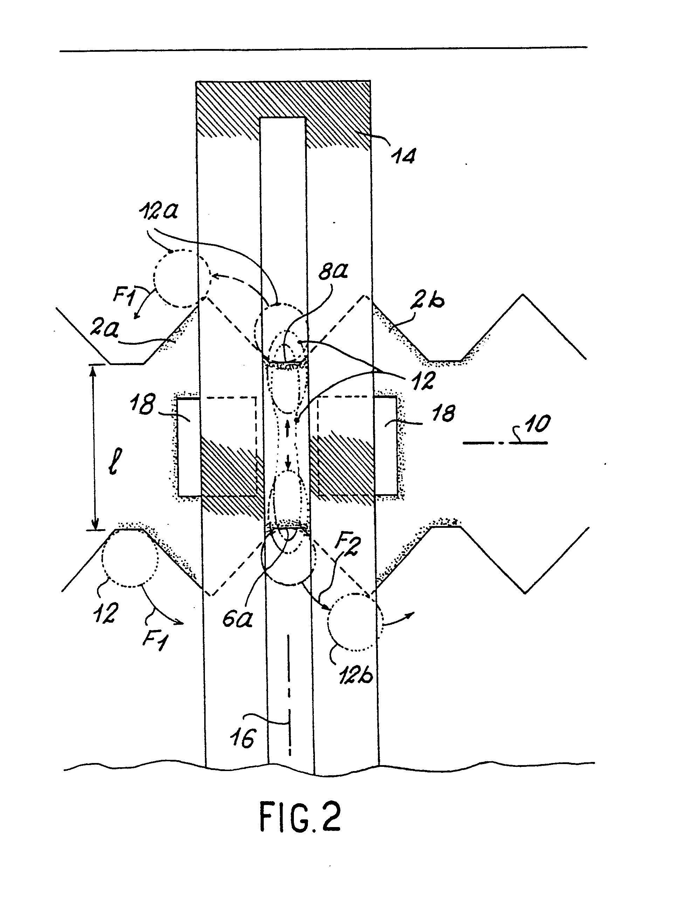

Comme représenté sur la figure 2, cette phase optimum se produit lorsque la bulle magnétique à dupliquer 12 est située dans l'une des cavités 6a ou 8a délimitées entre les deux motifs adjacents 2a et 2b situés au niveau du conducteur électrique 14. Dans ces conditions, l'application d'une impulsion de courant au conducteur électrique 14 entraîne l'allongement de la bulle à dupliquer de part et d'autre de l'ensemble de motifs 2, comme représenté sur la figure, puis la coupure de cette bulle en deux. De façon équivalente, l'arrêt de l'alimentation en courant du conducteur 14 se fait lorsque le champ magnétique $H_T$ est parallèle à l'axe 10 de l'ensemble de motifs de propagation 2. L'une des bulles 12a, obtenue par duplication, sera acheminée par le chemin de propagation $F_1$, afin d'être détectée, et l'autre bulle $12_b$, obtenue par duplication, sera scheminée par le chemin de propagation $F_2$ dans les registres de stockage de la mémoire.

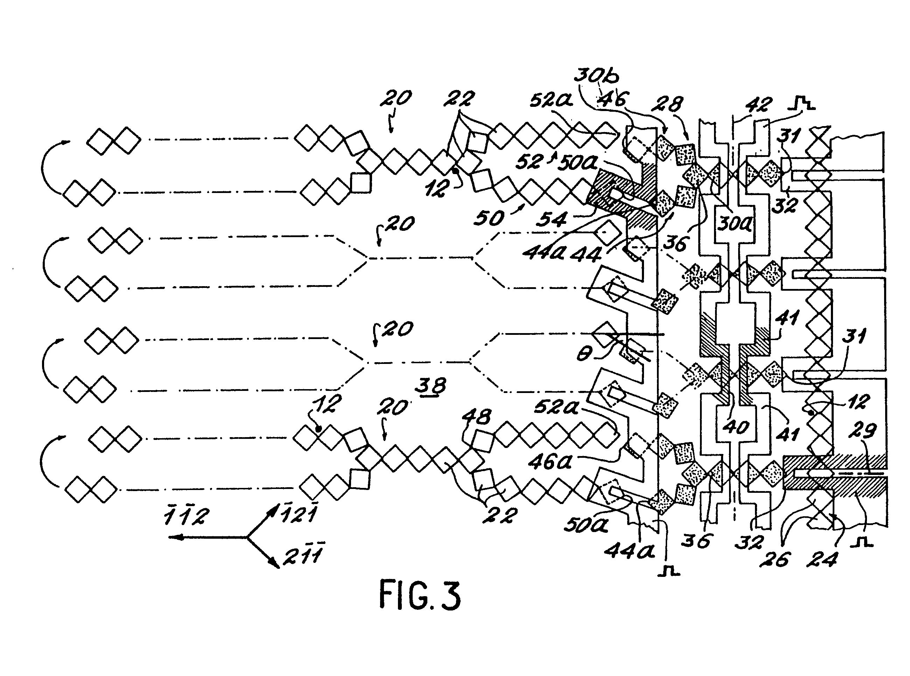

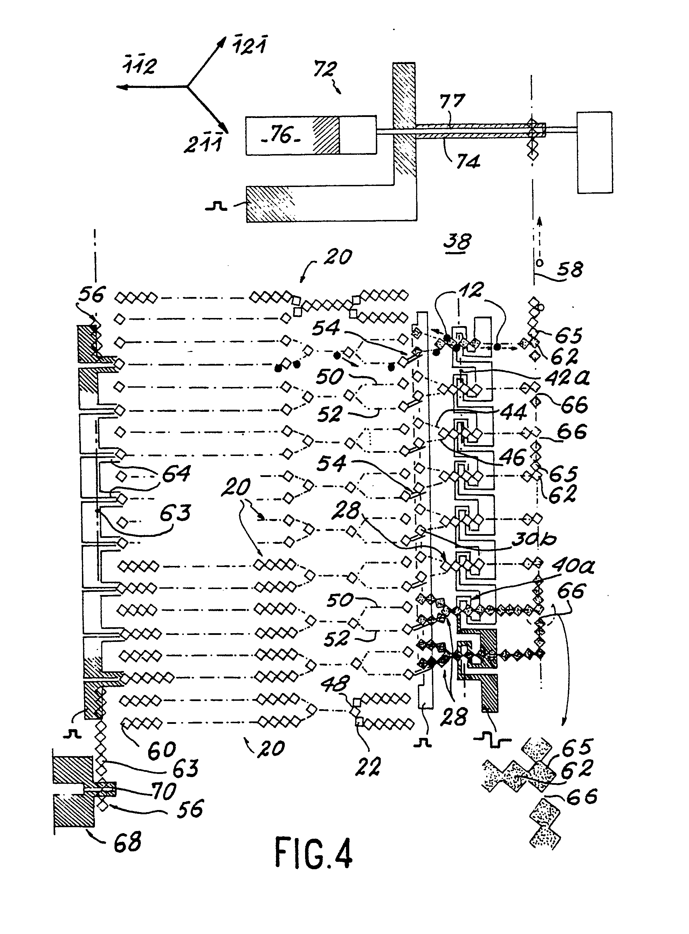

L'impulsion de courant nécessaire à la duplication peut présenter soit un seul niveau d'amplitude (figure 1), soit plusieurs niveaux d'amplitude de même signe (figure 3), soit plusieurs niveaux d'amplitude de signes contraires (figure 4).

Lorsque l'on désire effectuer la propagation et la duplication de bulles magnétiques présentant un diamètre de l'ordre de 2 microns, la distance $l$ (figure 2) séparant les régions les plus profondes des deux cavités par exemple 6a et 8a, délimitées entre deux motifs adjacents 2a et 2b, peut présenter une dimension comprise entre 2 et 20 microns.

Afin de faciliter la duplication des bulles magnétiques 12, les deux motifs 2a et 2b, traversés par le conducteur électrique 14, sont munis chacun d'une région implantée 18. Ces régions implantées 18 sont situées symétriquement par rapport à l'axe de symétrie 16 du conducteur électrique 14 et symétriquement par rapport à l'axe 10 de l'ensemble des motifs de propagation 2. L'obtention de ces régions implantées est réalisée simultanément à l'obtention des motifs de propagation 2, en effectuant l'implantation ionique à travers un masque approprié.

La structure telle que décrite précédemment peut être avantageusement utilisée dans une mémoire à bulles magnétiques présentant une organisation majeure-mineure. Sur la figure 3, on a représenté une telle organisation. Afin de simplifier la figure, les différents éléments constituent la mémoire ainsi que les bulles ont été représentés dans le même plan.

Cette mémoire à bulles comporte plusieurs boucles mineures 20 servant au stockage des bulles magnétiques 12, disposées les unes à côté des autres. Ces boucles mineures 20 sont formées chacune de motifs de propagation 22 non implantés et contigues, présentant par exemple des formes et des dimensions identiques. A ces boucles mineures 20 est associée une seule boucle majeure 24 servant de boucle d'accès aux boucles mineures 20. Cette boucle majeure 24 est utilisée aussi bien pour l'écriture et la lecture des informations. Cette boucle majeure 24, formée de motifs de propagation 26 non implantés et contigus, présentant par exemple des formes et des dimensions identiques, est disposée perpendiculairement aux boucles mineures 20. Les motifs de propagation des boucles mineures 20 et de la boucle majeure 24 présentent une forme telle que deux cavités sont définies entre deux motifs adjacents, par exemple une forme de losange.

Conformément à un mode préféré de réalisation de l'invention, le transfert des bulles magnétiques 12 de la boucle majeure 24 vers une boucle mineure 20, et le transfert réciproque, est assuré au moyen d'une ligne intermédiaire 28. A chaque boucle mineure 20 correspond une ligne interédiaire 28.

Selon un mode préféré de réalisation de l'invention, ces lignes intermédiaires 28, formées de motifs de propagation 30a et 30b non implantés et contigus, présentant une forme telle que deux cavités sont définies entre deux motifs adjacents, sont munies à leur extrémité 31, située en regard de la boucle majeure 24, d'une porte de transfert bidirectionnelle 32 assurant le transfert des bulles magnétiques 12 de la boucle majeure 24 vers la ligne intermédiaire 28 (lecture), et réciproquement (écriture). Ces portes de transfert bidirectionnelles 32 peuvent être formées chacune par un conducteur électrique par exemple en forme de U, traversant les motifs de propagation 26 de la boucle majeure 24, la base du U étant située en regard de ladite extrémité 31 de la ligne intermédiaire 28 correspondante.

Le transfert des bulles magnétiques au moyen des portes didirectionnelles 32 se fait, comme dans l'art antérieur, en appliquant une impulsion de courant au conducteur constituant ces portes; cette impulsion de courant permet d'étendre la bulle, se trouvent en regard d'un conducteur 32, entre les sommets des motifs de propagation 30a de la ligne 28 correspondante et les sommets des motifs de propagation 26 de la boucle majeure 24; l'arrêt de cette impulsion entraîne la contraction de la bulle sur la boucle majeure 24. Il est à noter que tous les conducteurs 32 sont reliés électriquement entre eux et qu'un transfert de bulles peut se faire simultanément, vers la boucle majeure ou vers les lignes intermédiaires, au niveau de tous ces conducteurs 32.

Les motifs de propagation 30a des lignes intermédiaires 28 sont, comme les motifs 2 des figures 1 et 2, alignés et disposés symétriquement par rapport à un axe 29, situé parallèlement à l'un des axes cristallographiques de facile aimantation de la couche de matériau magnétique 38 dans laquelle ils sont réalisés, cet axe cristallographique étant par exemple l'axe $\overline{1}1\overline{2}$, comme représenté sur la figure 3. Par ailleurs, ces motifs 30b peuvent être de forme et de dimensions identiques. De même, les motifs 30a d'une ligne intermédiaire 28 sont traversés par un conducteur électrique 40 présentant par exemple un axe de symétrie 42 disposé perpendiculairement à l'un des axes cristallographiques de la couche de matériau 38, comme par exemple l'axe cristallographique $\overline{1}1\overline{2}$. Les différents conducteurs 40 sont reliés électriquement entre eux au moyen de conducteurs 41.

Ces conducteurs 40, comme le conducteur électrique 14 des figures 1 et 2, permettent d'effectuer la duplication des bulles magnétiques 12, afin de lire les informations contenues dans les boucles mineures 20 de la mémoire. Cette duplication est réalisée simultanément au niveau de tous les conducteurs 40. Les conducteurs 40 sont disposés par rapport aux cavités définies entre deux motifs 30a adjacents de la ligne intermédiaire, comme précédemment. La duplication des bulles magnétiques au moyen de ces conducteurs électriques 40 se fait comme précédemment en leur appliquant une impulsion de courant à une phase bien déterminée de ce champ magnétique. Lors de la duplication d'une bulle, appelée bulle mère, une des deux bulles obtenues sera dirigée vers la porte bidirectionnelle 32 puis sur la boucle majeure 24 afin d'être détectée, l'autre bulle sera ré-injectée dans la boucle mineure 20 d'où la bulle magnétique mère, ou à dupliquer, avait été extraite, et à la place de cette dernière.

Comme précédemment, la duplication des bulles magnétiques au moyen des conducteurs 40 peut être facilitée en utilisant des motifs 30a de la ligne intermédiaire 28 correspondante comportant des régions implantées (figure 1), disposées symétriquement par rapport à l'axe 42 du conducteur 40 correspondant et par rapport à l'axe 29 de ces motifs.

L'extrémité 36 des lignes intermédiaires 28, situées en regard des boucles mineures 20 correspondantes, comprend deux embranchements distincts respectivement 46 et 44 formés de motifs non implantés et contigus 30b. Ces deux embranchements distincts 46 et 44 sont utilisés, respectivement, à l'injection des bulles magnétiques 12 dans la boucle mineure 20 correspondante et à l'extraction de ces bulles de ladite boucle.

Les boucles mineures 20 sont repliées de façon qu'elles définissent, au niveau de leur extrémité 48 en regard de la ligne intermédiaire 28 correspondante, deux morceaux distincts 52 et 50 servant respectivement à l'injection et à l'extraction des bulles magnétiques de la boucle mineure. Les boucles mineures sont dites repliées parce qu'elles sont faites de manière que, quand on se déplace le long d'une direction perpendiculaire à l'axe de l'une de ces boucles, on rencontre quatre positions possibles pour les bulles magnétiques de déplaçant sur cette boucle. Par ailleurs, les bulles introduites sur ces boucles mineures peuvent se déplacer indéfiniment sous l'action du champ magnétique $H_T$ appliqué à ces bulles.

Afin de permettre l'injection des bulles magnétiques dans les boucles mineures 20, l'extrémité 52a du morceau 52 de la boucle mineure correspondante 20 doit être disposée en regard de l'extrémité 46a de l'embranchement 46 de la ligne intermédiaire 28 correspondante. De préférence, les deux motifs de propagation en regard l'un de l'autre, c'est-à-dire le motif d'extrémité 30b de l'embranchement 46 et le motif d'extrémité 22 du morceau 52 de la boucle mineure 20 correspondante sont alignés de façon que cet alignement forme un angle θ voisin de 30° par rapport à l'un des axes cristallographiques de la couche magnétique 38 dans laquelle sont réalisés ces motifs 30b et 22, comme par exemple l'axe cristallographique $\overline{1}\overline{1}2$.

Les deux motifs d'extrémité 30b et 22 respectivement de l'embranchement 46 de la ligne intermédiaire 28 et du morceau 52 de la boucle mineure 20 correspondants constituent une fonction réunion, c'est-à-dire que les bulles magnétiques 12 qui viennent de la boucle majeure 24, via la ligne intermédiaire 28, lors de la nucléation (entrée d'informations) ou bien de la duplication (lecture d'une information), pénètrent sur la boucle mineure 20 correspondante tandis que les bulles qui sont sur cette boucle mineure (stockage d'informations) y demeurent.

De même, afin de permettre l'extraction des bulles magnétiques des boucles mineures 20, l'extrémité 50a du morceau 50 de la boucle mineure correspondante 20 doit être disposée en regard de l'extrémité 44a de l'embranchement 44 de la ligne intermédiaire 28 correspondante. Le transfert des bulles magnétiques entre le morceau 50 de la boucle mineure et l'embranchement 44 de la ligne intermédiaire est assuré au moyen d'une porte unidirectionnelle 54 constituée, par exemple par un conducteur électrique en forme de U. Le transfert de bulles magnétiques est assuré en appliquant au conducteur 54 une impulstion de courant comme précédemment. Il est à noter que tous les conducteurs 54 sont reliés électriquement entre eux et qu'un transfert de bulles peut se faire simultanément, vers les lignes intermédiaires 28, au niveau de tous ces conducteurs 54.

Afin d'éviter toutes perturbations entre l'injection et l'extraction des bulles magnétiques 12, au niveau des boucles mineures 20, l'embranchement 44 de la ligne intermédiaire et le morceau 50 de la boucle mineure d'une part, et l'embranchement 46 de la ligne intermédiaire et le morceau 52 de la boucle mineure d'autre part, doivent être suffisamment éloignés les uns des autres et orientés correctement les uns par rapport aux autres. Ceci est facilement réalisable par l'homme du métier.

Par ailleurs, les longueurs des morceaux 50 et 52 des boucles mineures 20, ainsi que la position du conducteur électrique 40 correspondant, servant à la duplication des bulles magnétiques, doivent être déterminées de manière précise. En particulier les longueurs des morceaux 50 et 52 des boucles mineures 20 doivent être telles que, lors de la duplication d'une bulle magnétique (lecture d'une information), la bulle magnétique obtenue par duplication qui revient sur la boucle mineure 20 doit parcourir un chemin égal à celui qu'elle aurait parcouru si elle était restée sur lu boucle mineure, c'est-à-dire que cette bulle doit revenir sur la boucle mineure, à la place qu'occupait la bulle à dupliquer.

Sur la figure 4, on a représenté une mémoire à bulles présentant une organisation comportant deux boucles majeures respectivement 56 et 58. Cette organisation est appelée organisation série-parallèle. Comme précédemment tous les éléments constituant la mémoire ainsi que les bulles magnétiques ont été représentés dans le même plan en vue d'une simplification de la figure. La boucle majeure 56 est utilisée pour introduire les bulles magnétiques sur les boucles mineures (entrée des informations) tandis que la boucle majeure 58 est utilisée pour la détection des bulles magnétiques (lecture des informations).

Sur cette figure, on retrouve les boucles mineures 20 comportant à leur extrémité 48 les deux morceaux 50 et 52, utilisés respectivement pour l'extraction et l'injection des bulles magnétiques des boucles mineures, les lignes intermédiaires 28 disposées respectivement en regard des morceaux 50 et 52 des boucles mineures 20 correspondantes, comportant leurs deux embranchements 44 et 46, ainsi que les conducteurs de duplication 40a, comportant par exemple un axe de symétrie 42a, associés chacun à l'une des lignes intermédiaires 28. Ces boucles mineures 20, ces lignes intermédiaires 28 et ces conducteurs 40a, présentent les mêmes caractéristiques que celles décrites précédemment (figure 3).

Sur cette figure, la boucle majeure 56 est située en regard de l'extrémité 60 des boucles mineures 20 tandis que la boucle majeure 58 est située à l'autre bout de la chaîne de motifs, c'est-à-dire dans le prolongement des extrémités 62 des lignes intermédiaires 28.

Dans cette mémoire, le transfert des bulles magnétiques 12 de la boucle majeure 56 vers les boucles mineures 20 est assuré au moyen de portes de transfert 64 qui peuvent être unidirectionnelles ou bidirectionnelles. Ces portes de transfert 64 sont constituées d'un conducteur électrique en forme de U, traversant les motifs de propagation 63 de la boucle majeure 56, la base du U étant située en regard de l'extrémité 60 des boucles mineures 20 correspondantes. Les conducteurs électriques 64 sont tous reliés électriquement entre eux.

Par ailleurs, le transfert des bulles magnétiques 12 des lignes intermédiaires 28 vers la boucle majeure 58 est assuré au moyen d'une fonction réunion, c'est-à-dire que les motifs de propagation 30a, au niveau des extrémités 62 des lignes intermédiaires 28, sont accolés à ceux de la boucle majeure 58. Afin d'assurer le transfert des bulles magnétiques, les motifs de propagation 65 de la boucle majeure 58 sont munis d'ouvertures 66, comme représenté sur la partie agrandie de la figure 4. Les bulles magnétiques 12 qui se déplacent le long des motifs 65 de propagation de la boucle majeure 58 ne sont nullement perturbées par ces ouvertures 66 qui présentent une dimension voisine de celle des bulles magnétiques, par exemple un diamètre de 2 microns.

Sur cette figure 4, on a représenté un générateur de bulles magnétiques 68 fonctionnant sur le principe de la nucléation. Ce générateur de bulles 68 est constitué, de façon classique d'un conducteur électrique 70, traversant les motifs de propagation 63 de la boucle majeure 56, auquel il peut être appliqué un courant électrique élevé entraînant le formation d'une bulle. De plus, on a représenté sur cette figure un détecteur de bulles magnétiques 72 associé à la boucle majeure 58. Ce détecteur 72, de conception classique, est constitué d'un conducteur électrique 74, traversant les motifs de propagation 65 de la boucle majeure 58, et d'un élément 76 en forme de barreau, réalisé en un matériau magnéto-résistif, généralement à base de fer et de nickel. La détection d'une bulle magnétique se fait en appliquant une impulsion de courant au conducteur électrique 74, permettant d'allonger la bulle sur une longueur de 100 microns environ, dans l'espace utile 77 du conducteur 74. La bulle détectée est ensuite annihilée ou détruite de façon que le détecteur 72 soit prêt à détecter une autre bulle. La destruction d'une bulle magnétique correspond à la transformation de cette bulle en un signal électrique.

Les mémoires à bulles magnétiques présentant une organisation majeure-mineure ou série-parallèle, peuvent être utilisées comme les mémoires de l'art antérieur pour effectuer de la duplication bulle par bulle, c'est-à-dire élément binaire par élément binaire. De plus, ces mémoires à bulles, étant donné la disposition relative des éléments la constituant ainsi que la structure de chacun de ces éléments et, notamment la disposition des lignes intermédiaires 28 par rapport à l'axe cristallographique de la couche de matériau dans laquelle elles sont réalisées, la structure de ces lignes et la disposition des conducteurs de duplication 40 et 40a par rapport audit axe, permettent d'effectuer la duplication d'un ensemble ou bloc de bulles, c'est-à-dire d'un bloc d'éléments binaires; ceci n'était pas possible avec les mémoires à bulles de l'art antérieur utilisant des motifs non implantés.

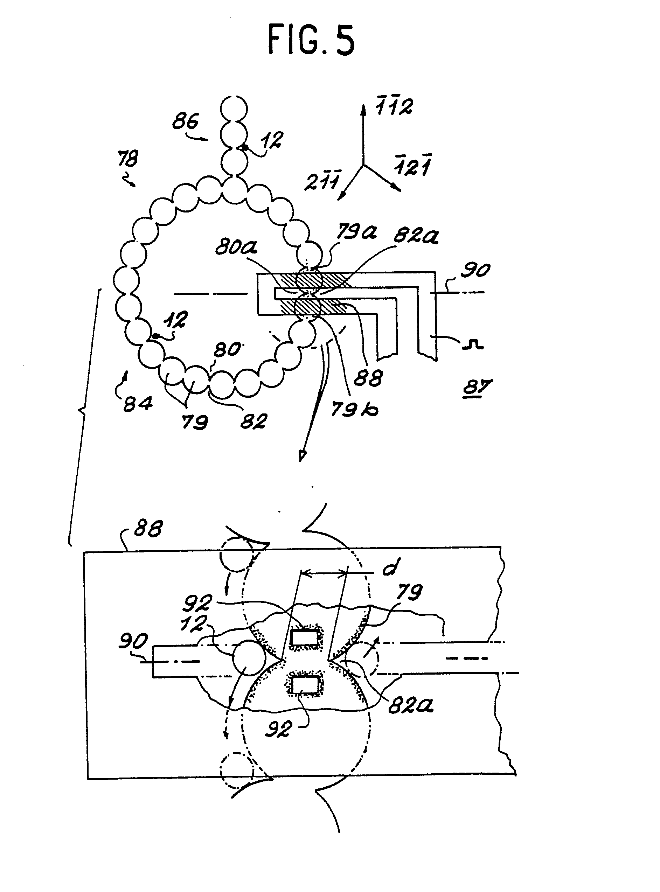

Conformément à l'invention, le générateur de bulles magnétiques fonctionnant sur le principe de la nucléation, comme par exemple le générateur 68 de le figure 4, peut être remplacé par un générateur fonctionnant sur le principe de la duplication des bulles magnétiques. Un tel générateur est représenté sur la figure 5. Comme précédemment, en vue d'une simplification de la figure, les éléments constituant ce générateur ainsi que les bulles ont été représentés dans le même plan.

Ce générateur portant la référence générale 78, est constitué d'un ensemble de motifs de propagation 79 non implantés et contigus, présentant une forme telle que deux cavités 80 et 82 soient définies entre deux motifs 79 adjacents. Ces motifs 79 obtenus comme précédemment, présentent, de préférence la forme de cercles, comme représentés sur la figure, ou de polygones tels que des triangles ou des hexagones. Par ailleurs, ces motifs 79 possèdent des formes et des dimensions identiques. Ces motifs 79 sont disposés, pour une partie, de façon à former une boucle fermée 84 tandis que les autres motifs 79 sont disposés suivant un chemin de propagation, portant la référence 86. Comme représenté sur la figure, le chemin de propagation 86 peut être disposé parallèlement à l'un des axes cristallographiques de la couche de matériau magnétique 87 (grenat magnétique) dans laquelle sont réalisés les motifs 79, par exemple l'axe cristallographique $\overline{11}2$. Le déplacement des bulles magnétiques le long des motifs 79, aussi bien pour la partie bouclée 84 que pour la partie alignée 86, se fait comme précédemment au moyen d'un champ magnétique tournant $H_T$ appliqué parallèlement à la couche de matériau magnétique contenant les bulles.

Afin d'obtenir la duplication des bulles magnétiques 12 se propageant le long des motifs 79 de la boucle 84, on utilise, comme précédemment, un conducteur électrique 88, présentant par exemple un axe de symétrie 90, disposé perpendiculairement à l'un des axes cristallographiques de la couche de matériau magnétique 87, par exemple l'axe cristallographique $\overline{11}2$.

Comme précédemment, (figures 1 et 2), l'axe de symétrie 90 de ce conducteur électrique passe par les deux cavités 80a et 82a, délimitées par deux motifs adjacents 79a et 79b situés au niveau de ce conducteur, et au niveau de la région la plus profonde de ces cavités. La duplication des bulles magétiques 12, se trouvant dans l'une des cavités 80a ou 82a, se fait en appliquant une impulsion de courant électrique au conducteur électrique 82, comme représenté sur la figure. Cette impulsion est appliquée uniquement lorsque l'on désire engendrer une bulle, c'est-à-dire enregistrer une information dans la mémoire. Cette impulsion peut présenter un ou plusieurs niveaux d'amplitude de même signe ou de signes contraires. L'une des bulles, obtenue par duplication, est envoyée vers les boucles majeures ou d'accès de la mémoire, par l'intermédiaire de la partie de motifs de présentant la forme d'une ligne, l'autre bulle de la duplication est ré-injectée dans le boucle 84.

De plus, pour faciliter la duplication des bulles magnétiques des régions implantées 92, réalisées dans les motifs non implantés 79a et 79b, situés au niveau du conducteur électrique 88, peuvent être prévues, comme représenté sur la partie agrandie de la figure 5. Ces régions sont situées symétriquement par rapport à l'axe de symétrie 90 du conducteur 88.

L'introduction des bulles magnétiques à l'intérieur de la boucle 84 de motifs 79 peut être réalisée lors de l'initialisation de la mémoire, en envoyant des impulsions de courant d'amplitude appropriées. Ceci peut être réalisé jusqu'à remplissage complet de la boucle 84 par des bulles magnétiques. Lorsque la boucle 84 est remplie de bulles, on peut engendrer des éléments d'informations "1", c'est-à-dire une bulle, en dupliquant une bulle contenue dans la boucle 84, au moyen du conducteur électrique 88.

Afin, d'assurer une bonne stabilité des bulles magnétiques contenues dans la boucle fermée 84, il est préférable, selon l'invention, que cette boucle présente la symétrie ternaire (trois axes cristallographiques) de la couche de matériau magnétique 87 dans laquelle les motifs de propagation 79 sont réalisés. Il est à noter que cette couche magnétique 87 est en fait la même que celle contenant les boucles majeures et mineures de la mémoire.

Pour effectuer la propagation et la duplication de bulles magnétiques présentant un diamètre de l'ordre de 2 microns, la distance $d$ séparant les régions les plus profondes des deux cavités par exemple 80a et 82a, délimitées entre deux motifs adjacents 79a et 79b peuvent présenter une dimension comprise entre 2 et 20 microns (partie agrandie de la figure 5).

## Revendications

1. Mémoire à bulles magnétiques comportant une première couche de matériau magnétique monocristallin (4, 38, 87) présentant au moins un axe cristallographique plan de facile aimantation ($\overline{11}2$), des ensembles de motifs non implantés (2, 30a) contigüs et alignés, dits premiers motifs, formés dans la première couche et permettant la propagation des bulles (12) dans une seconde couche magnétique (5), située en dessous de la première couche, ces premiers motifs (2, 30a) possédant une forme telle que deux cavités (6, 8) sont délimitées entre deux premiers motifs adjacents, chaque ensemble de premiers motifs (2, 30a) présentant un axe (10, 29) tel que les premiers motifs dudit ensemble sont disposés symétriquement par rapport à cet axe, un conducteur électrique, dit premier conducteur (14, 40, 40a), associé à chaque ensemble et traversant ledit ensemble, et des moyens pour appliquer parallèlement à la seconde couche (5) un champ magnétique continu tournant ($H_T$), présentant une période de rotation donnée, caractérisée en ce que, les ensembles de motifs sont disposés parallèlement à l'axe cristallographique ($\overline{11}2$) de la première couche (4, 38, 87), chaque premier conducteur (14, 40, 40a) est disposé perpendiculairement à l'axe cristallographique ($\overline{11}2$) de ladite première couche, les deux premiers motifs adjacents (2a, 2b) d'un même ensemble, situés à l'endroit où est disposé le premier conducteur associé, présentant chacun une région implantée (18), ces régions étant situées symétriquement par rapport audit premier conducteur et symétriquement par rapport à l'axe (10) de cet ensemble de premiers motifs (2), et en ce qu'elle comprend des moyens pour appliquer sur chaque premier conducteur au moins une impulsion de courant, entraînant une duplication de la bulle (12) logée dans l'une des cavités (6a, 8a) délimitées par les deux premiers motifs adjacents situés au niveau de ce premier conducteur, cette duplication consistant en un allongement des bulles de part et d'autre de l'ensemble de motifs associés à ce premier conducteur et en une coupure de ces bulles en deux, et des moyens pour arrêter l'alimentation en courant de ce premier conducteur (14, 40, 40a) lorsque le champ magnétique ($H_T$) est parallèle à l'axe (10, 29) de l'ensemble de motifs associé.

2. Mémoire à bulles selon la revendication 1, caractérisée en ce que chaque premier conducteur électrique (14) présente un axe de symétrie (16) et est disposé de façon que cet axe de symétrie (16) passe par les deux cavités (6a, 8a) délimitées par deux premiers motifs adjacents (2a, 2b) de l'ensemble qui lui est associé et au niveau de la région la plus profonde de ces cavités.

3. Mémoire à bulles selon la revendication 1 caractérisée en ce que les premiers motifs (2, 30a) présentent des formes et des dimensions identiques.

4. Mémoire à bulles selon l'une quelconque des revendications 1 à 3, caractérisée en ce que la distance ($l$) séparant les régions les plus profondes des deux cavités (6, 8) délimitées entre deux premiers motifs adjacents (2) d'un même ensemble, est comprise entre 2 à 20 µm pour des bulles (12) de 2 µm environ.

5. Mémoire à bulles selon l'une quelconque des revendications 1 à 4, comportant, en outre, des boucles mineures (20) servant au stockage des bulles (12), disposées les unes à côté des autres et comportant chacune deux extrémités (48, 60), ces boucles mineures (20) étant formées de motifs de propagation (22) non implantés et contigus, dits seconds motifs, au moins une boucle majeure (24, 56, 58) servant de boucle, d'accès aux boucles mineures (20), disposée perpendiculairement aux boucles mineures, cette boucle majeure (24, 56, 58) étant formée de motifs de propagation (26, 63, 65), non implantés et contigus, dits troisièmes motifs, et des moyens (68, 72, 78) pour détecter et engrendrer des bulles (12) sur la boucle majeure, caractérisée en ce que chaque boucle mineure (20) est repliée de façon qu'elle définisse, à l'une de ses extrémités (48), deux morceaux distincts (52, 50) situés l'un à côté de l'autre, le premier morceau (52) servant à l'injection de bulles (12) dans cette boucle mineure (20) et le second morceau (50) à l'extraction de bulles (12) de cette boucle mineure (20), et en ce que chaque boucle mineure (20) est associée à un ensemble de premiers motifs (28), servant au transfert des bulles (12) de la boucle mineure (20) correspondante vers la boucle majeure (24, 56, 58), et réciproquement, ces ensembles de premiers motifs (28) comportant à l'une de leurs extrémités (36) deux embranchements distincts, un premier embranchement (46) servant à l'injection de bulles (12) dans la boucle mineure (20) correspondante et un second embranchement (44) servant à l'extraction de bulles (12) de la boucle mineure (20) correspondante, lesdits embranchements, formés de motifs de propagation (30b) non implantés, contigus et alignés, dits quatrièmes motifs, étant situés l'un à côté de l'autre de façon que l'extrémité (46a) du premier embranchement (46) soit en regard de l'extrémité (52a) du premier morceau (52) de la boucle mineure (20) correspondante et que l'extrémité (44a) du second embranchement (44) soit en regard de l'extrémité (50a) du second morceau (50) de la boucle mineure (20) correspondante, l'extrémité (50a) du second embranchement (50) étant munie d'une porte de transfert unidirectionnelle (54) pour assurer le transfert des bulles (12) de la boucle mineure (20) vers l'ensemble de motifs associé (28).

6. Mémoire à bulles selon la revendication 5, caractérisée en ce que le quatrème motif d'extrémité (30b) dudit premier embranchement (46) et le second motif d'extrémité (22) dudit premier morceau (52) de la boucle mineure (20), situés en regard l'un de l'autre, sont alignés, cet alignement formant un angle voisin de 30° avec l'axe cristallographique ($\overline{1}\overline{1}2$) de la première couche magnétique (38).

7. Mémoire à bulles selon l'une quelconque des revendications 5 et 6, caractérisée en ce que les portes de transfert unidirectionnelles (54) sont formées par des conducteurs électriques en forme de U.

8. Mémoire à bulles selon l'une quelconque des revendications 5 à 7, caractérisée en ce que les deux morceaux (50, 52) des boucles mineures (20) présentent une longueur telle qu'une bulle (12), obtenue par duplication d'une bulle mère, revienne sur la boucle mineure (20) à la place qu'occupait la bulle mère.

9. Mémoire à bulles selon l'une quelconque des revendications 5 à 8, caractérisée en ce que les ensembles de premiers motifs (28) comportent à leur autre extrémité (31) une porte de transfert bidirectionnelle (32) pour assurer le transfert des bulles (12) de la boucle majeure (24) vers ces ensembles de motifs (28), et réciproquement.

10. Mémoire à bulles selon l'une quelconque des revendications 5 à 8, comportant deux boucles majeures (56, 58), la première (58) étant en regard des moyens de détection (72) des bulles (12) et la seconde (56) en regard des moyens permettant d'engendrer les bulles (68, 78), caractérisée en ce que les ensembles de premiers motifs (28) sont accolés, au niveau de leur autre extrémité (62), à la première boucle majeure (58), cette boucle majeure (58) comportant des ouvertures (66), pratiquées dans les troisièmes motifs (65) non implantés la constituant, permettant le transfert des bulles (12) de l'ensemble de premiers motifs (28) vers cette boucle majeure, et en ce que l'autre extrémité (60) des boucles mineures (20) comporte une porte de transfert (64) permettant le transfert des bulles (12) de ces boucles mineures (20) à la deuxième boucle majeure (56), et réciproquement.

11. Mémoire à bulles selon l'une quelconque des revendications 5 à 10, caractérisée en ce que les moyens (78) pour engendrer les bulles (12) comprennent un ensemble de motifs de propagation (79) non implantés contigus, dits cinquièmes motifs, possédant une forme telle que deux cavités (80, 82) sont délimitées entre deux motifs adjacents (79), une partie de ces motifs (79) étant disposée de façon à former une boucle fermée (84), l'autre partie (86) constituant un chemin de propagation pour les bulles engendrées et un conducteur électrique (88), dit second conducteur, permettant la duplication de bulles (12), lorsqu'on lui applique au moins une impulsion de courant, disposé perpendiculairement à l'axe cristallographique ($\overline{1}\overline{1}2$) de la première couche magnétique (87), ledit ensemble de cinquièmes motifs étant traversé par ce second conducteur, au niveau de la partie en forme de boucle formée (84).

12. Mémoire à bulles selon la revendication 11, caractérisée en ce que la première couche magnétique (87) présentant trois axes cristallographiques, la boucle fermée (84) possède la symétrie d'ordre trois de cette couche magnétique.

13. Mémoire à bulles selon l'une quelconque des revendications 11 et 12, caractérisée en ce que le second conducteur électrique (88) présente un axe de symétrie (90) et est disposé de façon que son axe de symétrie (90) passe par les deux cavités (80a, 82a) délimitées par deux cinquièmes motifs (79a, 79b) adjacents et au niveau de la région la plus profonde de ces cavités.

14. Mémoire à bulles selon l'une quelconque des revendications 11 à 13, caractérisée en ce que les cinquièmes motifs (79) présentent des formes et des dimensions identiques.

15. Mémoire à bulles selon l'une quelconque des revendications 11 à 14, caractérisée en ce que les cinquièmes motifs (79) présentent la forme de cercles, de triangles ou d'hexagones.

16. Mémoires à bulles selon l'une quelconque des revendications 11 à 15, caractérisée en ce que les cinquièmes motifs adjacents (79a, 79b), situés à l'endroit du second conducteur électrique (88) présentent chacun une région implantée (92), ces régions (92) étant disposées symétriquement par rapport à l'axe de symétrie (90) du second conducteur (88).

17. Mémoire à bulles selon l'une quelconque des revendications 11 à 16, caractérisée en ce que la distance (d) séparant les régions les plus profondes des deux cavités (80a, 82a) délimitées entre deux cinquièmes motifs adjacents (79a, 79b) est comprise entre 2 et 20 µm pour des bulles de 2 µm environ.

18. Mémoire à bulles selon l'une quelconque des revendications 1 à 17, caractérisée en ce que l'impulsion de courant présente un seul niveau d'amplitude.

19. Mémoire à bulles selon l'une quelconque des revendications 1 à 17, caractérisée en ce que l'impulsion de courant présente plusieurs niveaux d'amplitude de même signe.

20. Mémoire à bulles selon l'une quelconque des revendications 1 à 17, caractérisée en ce que l'impulsion de courant présente plusieurs niveaux d'amplitude de signes contraires.

21. Application de la mémoire à bulles selon l'une quelconque des revendications 1 à 20 à la duplication d'élément binaire par élément binaire, la duplication étant réalisée en alimentant les conducteurs électriques servant à la duplication par des impulsions successives de courant.

22. Application de la mémoire à bulles selon l'une quelconque des revendications 1 à 20 à la duplication par bloc d'éléments binaires.

**Patentansprüche**

1. Magnetblasenspeicher mit einer ersten Schicht aus magnetischem, monokristallinem Material (4, 38, 87), die wenigstens eine ebene kristallographische Achse leichter Magnetisierung ($\overline{1}1\overline{2}$) aufweist, mit Gesamtheiten von nicht-implantierten, aneinanderstoßenden und ausgerichteten Mustern (2, 30a), die erste Muster genannt werden und in der ersten Schicht ausgebildet sind und die Wanderung von Blasen (12) in einer zweiten, magnetischen Schicht (5) ermöglichen, die sich unter der ersten Schicht befindet, wobei diese ersten Muster (2, 30a) eine solche Form aufweisen, daß zwei Hohlräume (6, 8) zwischen zwei benachbarten ersten Mustern begrenzt sind, und die Gesamtheit der ersten Muster (2, 30a) eine Achse (10, 29) aufweist derart, daß die ersten Muster der genannten Gesamtheit symmetrisch in Bezug auf diese Achse angeordnet sind, sowie mit einem elektrischen Leiter, erster Leiter (14, 40, 40a) genannt, der jeder Gesamtheit zugeordnet ist und die Gesamtheit überquert, und mit Mitteln, um parallel zu der zweiten Schicht (5) ein kontinuierliches, magnetisches Drehfeld ($H_T$) anzuwenden, welches eine gegebene Drehperiode aufweist, dadurch gekennzeichnet, daß die Gesamtheiten der Muster parallel zu der kristallographischen Achse (112) der ersten Schicht (4, 38, 87) angeordnet sind, jeder erste Leiter (14, 40, 40a) senkrecht zu der kristallographischen Achse ($\overline{1}1\overline{2}$) der ersten Schicht angeordnet ist, die zwei benachbarten ersten Muster (2a, 2b) derselben Gesamtheit, die sich an der Stelle befinden, wo der erste zugeordnete Leiter angeordnet ist, jeweils einen implantierten Bereich (18) aufweisen, diese Bereiche symmetrisch in Bezug auf den ersten Leiter und symmetrisch in Bezug auf die Achse (10) dieser Gesamtheit von ersten Mustern (2) angeordnet sind, und daß der Speicher Mittel aufweist, um an jeden ersten Leiter mindestens einen Stromimpuls anzulegen, der eine Verdoppelung der Blase (12) zur Folge hat, die sich in einer der Vertiefungen (6a, 8a) befindet, die von den zwei sich auf der Höhe des ersten Leiters befindenden, benachbarten, ersten Mustern begrenzt sind, wobei diese Verdoppelung in einer Verlängerung der Blasen beidseitig der Gesamtheit von Mustern, die diesem ersten Leiter zugeordnet sind, und einem Entzweischneiden dieser Blasen besteht, und Mittel umfaßt, um die Stromversorgung dieses ersten Leiters (14, 40, 40a) zu unterbrechen, wenn das Magnetfeld ($H_T$) parallel zu der Achse (10, 29) der zugeordneten Gesamtheit von Mustern verläuft.

2. Blasenspeicher nach Anspruch 1, dadurch gekennzeichnet, daß jeder erste elektrische Leiter (14) eine Symmetrieachse (16) aufweist und derart angeordnet ist, daß diese Symmetrieachse (16) durch die zwei Vertiefungen (6a, 8a), die von zwei benachbarten ersten Mustern (2a, 2b) der Gesamtheit begrenzt sind, die ihm zugeordnet ist, und durch die tiefsten Bereiche dieser Vertiefungen hindurchgeht.

3. Blasenspeicher nach Anspruch 1, dadurch gekennzeichnet, daß die ersten Muster (2, 30a) identische Formen und Abmessungen aufweisen.

4. Blasenspeicher nach einem der Ansprüche 1 bis 3, dadurch gekennzeichnet, daß der Abstand (l), der die tiefsten Bereiche der zwei Vertiefungen (6, 8) trennt, die zwischen zwei ersten benachbarten Mustern (2) derselben Gesamtheit begrenzt sind, zwischen 2 und 20 µm für Blasen (12) von ungefähr 2 µm beträgt.

5. Blasenspeicher nach einem der Ansprüche 1 bis 4, mit ferner kleineren, der Speicherung von Blasen (12) dienenden Schleifen (20), die Seite an Seite angeordnet sind und jeweils zwei Enden (48, 60) aufweisen, wobei diese kleineren Schleifen (20) von nicht-implantierten und aneinanderstoßenden Wandermustern (22), zweite Muster genannt, gebildet werden, mit wenigstens einem als Zugriffsschleife zu den kleineren Schleifen (20) dienenden größeren Schleife (24, 56, 58), die senkrecht zu den kleineren Schleifen angeordnet ist, wobei diese größere Schleife (24, 56, 58) von nicht-implantierten und aneinanderstoßenden Wandermustern (26, 43, 65), dritte Muster genannt, gebildet ist, und mit Mitteln (68, 72, 78), um auf der größeren Schleife Blasen (12) zu erfassen und zu erzeugen, dadurch gekennzeichnet, daß jede kleinere Schleife (20) derart aufgebogen ist, daß sie an einem ihrer Enden (48) zwei bestimmte, sich Seite an Seite befindende Teile (52, 50) festlegt, wobei der erste Teil (52) zum Einbringen von Blasen (12) in diese kleinere Schleife (20) und der zweite Teil (50) zum Herausholen von Blasen (12) aus dieser kleineren Schleife (20) dient, und daß jede kleinere Schleife (20) einer Gesamtheit von ersten Mustern (28) zugeordnet ist, die zum Überführen von Blasen (12) von der entsprechenden kleineren Schleife (20) zu der größeren Schleife (24, 56, 58) und umgekehrt dient, daß diese Gesamtheiten von ersten Mustern (28) an einem ihrer Enden (36) zwei verschiedene Zweige aufweist, wobei ein erster Zweig (46) zum Einbringen von Blasen (12) in die entsprechende kleinere Schleife (20) und ein zweiter Zweig (44) zum Herausholen von Blasen (12) aus der entsprechenden kleineren Schleife (20) dient, daß sich die von nicht-implantierten, aneinanderstoßenden und ausgerichteten Wandermustern (30b), vierte Muster genannt, gebildeten Zweige nebeneinander derart befinden, daß das Ende (46a) des ersten Zweigs (46) dem Ende (52a) des ersten Teils (52) der entsprechenden kleineren Schleife (20) gegenüberliegt und das Ende (44a) des zweiten Zweigs (44) dem Ende (50a) des zweiten Teils (50) der entsprechenden kleineren Schleife (20) gegenüberliegt, wobei das Ende (50a) des zweiten Zweigs (50) mit einem Einwegüberführungstor (54) versehen ist, um das Überführen der Blasen (12) der kleineren Schleife (20) zu der zugeordneten Gesamtheit (28) von Mustern sicherzustellen.

6. Blasenspeicher nach Anspruch 5, dadurch gekennzeichnet, daß das vierte Muster des Endes (30b) des ersten Zweigs (46) und das zweite Muster des Endes (22) des ersten Teils (52) der kleineren Schleife (20), die einander gegenüberliegen, ausgerichtet sind, wobei diese Ausrichtung einen Winkel von etwa 30° mit der kristallographischen Achse ($\overline{11}2$) der ersten, magnetischen Schicht (38) bildet.

7. Blasenspeicher nach Anspruch 5 oder 6, dadurch gekennzeichnet, daß die Einwegüberführungstore (54) von U-förmigen, elektrischen Leitern gebildet sind.

8. Blasenspeicher nach einem der Ansprüche 5 bis 7, dadurch gekennzeichnet, daß die zwei Teile (50, 52) der kleineren Schleifen (20) eine derartige Länge aufweisen, daß eine durch Verdoppelung einer Mutterblase erhaltene Blase (12) zu der kleineren Schleife (20) an die Stelle zurückkommt, die die Mutterblase einnahm.

9. Blasenspeicher nach einem der Ansprüche 5 bis 8, dadurch gekennzeichnet, daß die Gesamtheiten von ersten Mustern (28) an ihrem anderen Ende (31) ein Zweiwegüberführungstor (32) aufweisen, um die Überführung von Blasen (12) von der größeren Schleife (24) zu diesen Gesamtheiten von Mustern (28) und umgekehrt sicherzustellen.

10. Blasenspeicher nach einem der Ansprüche 5 bis 8, mit zwei größeren Schleifen (56, 58), von denen die erste (58) Erfassungsmitteln (72) für Blasen (12) gegenüberliegtnd und die zweite (56) Mitteln gegenüberliegt, die das Erzeugen von Blasen (68, 78) ermöglichen, dadurch gekennzeichnet, daß die Gesamtheiten von ersten Mustern (28) an ihren anderen Enden (62) an die erste größere Schleife (58) angehängt sind, diese größere Schleife (58) öffnungen (66) aufweist, die in den sie bildenden, nicht-implantierten, dritten Mustern (65) hergestellt sind und die Überführung von Blasen (12) von der Gesamtheit der ersten Muster (28) zu dieser größeren Schleife erlauben, und daß das andere Ende (60) der kleineren Schleifen (20) ein Überführungstor (64) aufweist, welches die Überführung von Blasen (12) dieser kleineren Schleifen (20) zu der zweiten größeren Schleife (56) und umgekehrt ermöglicht.

11. Blasenspeicher nach einem der Ansprüche 5 bis 10, dadurch gekennzeichnet, daß die Mittel (78) zum Erzeugen von Blasen (12) eine Gesamtheit von nicht-implantierten, aneinanderstoßenden Wandermustern (79), fünfte Muster genannt, aufweisen, die eine derartige Form besitzen, daß zwei Vertiefungen (80, 82) zwischen zwei benachbarten Mustern (79) begrenzt sind, wobei ein Teil dieser Muster (79) so angeordnet ist, daß er eine geschlossene Schleife (84) bildet, und der andere Teil (86) einen Wanderweg für die erzeugten Blasen darstellt, und einen elektrischen Leiter (88), zweiter Leiter genannt, umfassen, der die Verdoppelung von Blasen (12) ermöglicht, wenn man an ihn wenigstens einen Stromimpuls anlegt, und der senkrecht zu der kristallographischen Achse ($\overline{11}2$) der ersten, magnetischen Schicht (87) angeordnet ist, wobei die Gesamtheit der fünften Muster von diesem zweiten Leiter bei dem Teil überquert wird, der die Form einer geschlossenen Schleife (84) hat.

12. Blasenspeicher nach Anspruch 11, dadurch gekennzeichnet, daß die erste, magnetische Schicht (87) drei kristallographische Achsen aufweist und die geschlossene Schleife (84) die Symmetrie der dritten Ördnung dieser magnetischen Schicht besitzt.

13. Blasenspeicher nach Anspruch 11 oder 12, dadurch gekennzeichnet, daß der zweite, elektrische Leiter (88) eine Symmetrieachse (90) aufweist und derart angeordnet ist, daß seine Symmetrieachse (90) durch die zwei Vertiefungen (80a, 82a), die durch zwei benachbarte fünfte Muster (79a, 79b) begrenzt sind, und durch den tiefsten Bereich dieser Vertiefungen hindurchgeht.

14. Blasenspeicher nach einem der Ansprüche 11 bis 13, dadurch gekennzeichnet, daß die fünften Muster (79) identische Formen und Abmessungen aufweisen.

15. Blasenspeicher nach einem der Ansprüche 11 bis 14, dadurch gekennzeichnet, daß die fünften Muster (79) die Form von Kreisen, Dreiecken oder Sechsecken aufweisen.

16. Blasenspeicher nach einem der Ansprüche 11 bis 15, dadurch gekennzeichnet, daß die benachbarten fünften Muster (79a, 79b), die sich an der Stelle des zweiten, elektrischen Leiters (88) befinden, jeweils einen implantierten Bereich (92) aufweisen, wobei diese Bereiche (92) symmetrisch in Bezug auf die Symmetrieachse (90) des zweiten Leiters (88) angeordnet sind.

17. Blasenspeicher nach einem der Ansprüche 11 bis 16, dadurch gekennzeichnet, daß der Abstand (d), der die tiefsten Bereiche der zwei Vertiefungen (80a, 82a), die zwischen zwei benachbarten fünften Mustern (79a, 79b) begrenzt sind, trennt, zwischen 2 und 20 µm für Blasen von ungefähr 2 µm beträgt.

18. Blasenspeicher nach einem der Ansprüche 1 bis 17, dadurch gekennzeichnet, daß der Stromimpuls einen einzigen Amplitudenpegel aufweist.

19. Blasenspeicher nach einem der Ansprüche 1 bis 17, dadurch gekennzeichnet, daß der Stromimpuls mehrere Amplitudenpegel mit gleichem Vorzeichen aufweist.

20. Blasenspeicher nach einem der Ansprüche 1 bis 17, dadurch gekennzeichnet, daß der Stromimpuls mehrere Amplitudenpegel mit entgegengesetzten Vorzeichen aufweist.

21. Anwendung des Blasenspeichers nach einem der Ansprüche 1 bis 20 auf die die Binärelementverdopplung pro Binärelement, wobei die Verdopplung dadurch hervorgerufen wird, daß die elektrischen Leiter, die der Verdoppelung dienen, mit aufeinanderfolgenden Stromimpulsen versorgt werden.

22. Anwendung des Blasenspeichers nach einem der Ansprüche 1 bis 20 bei der Verdopplung von Blöcken von binärelementen.

**Claims**

1. Magnetic bubble memory having a first layer of monocrystalline magnetic material (4, 38, 87) having at least one planar easy magnetization crystallographic axis $(\overline{112})$, groups of unimplanted (2, 30a), contiguous and aligned patterns, called first patterns, formed in the first layer and permitting the propagation of the bubbles (12) into a second magnetic layer (5), positioned below the first magnetic layer, said first patterns (2, 30a) being shaped in such a way that two cavities (6, 8) are defined between two first adjacent patterns, each group of first patterns (2, 30a) having an axis (10, 29) such that the first patterns of said group are arranged symmetrically with respect to said axis, an electrical conductor, called the first conductor (14, 40, 40a), associated with each group and traversing the latter and means for applying parallel to said second layer (5) a continuous rotary magnetic field ($H_T$) having a given rotation period, characterized in that the groups of patterns are arranged parallel to the crystallographic axis $(\overline{112})$ of the first layer (4, 38, 87), each first conductor (14, 40, 40a) being positioned perpendicular to the crystallographic axis (112) of said first layer, the two first adjacent patterns (2a, 2b) of a first group, located at the point where the first associated conductor is located, each having an implanted region (18), said regions being symmetrical with respect to said first conductor and symmetrical with respect to axis (10) of said group of first patterns (2) and in that it comprises means for applying to each first conductor at least one current pulse, leading to a duplication of the bubble (12) located in one of the cavities (6a, 8a) defined by the two first adjacent patterns located level with said first conductor, said duplication consisting of an elongation of the bubbles on either side of the group of patterns associated with said first conductor and in a subdivision of said bubbles into two, and means for stopping the power supply of said first conductor (14, 40, 40a) when the magnetic field ($H_T$) is parallel to the axis (10, 29) of the group of associated patterns.

2. Bubble memory according to claim 1, characterized in that each first electrical conductor (14) has an axis of symmetry (16) and is positioned in such a way that said axis of symmetry (16) passed through the two cavities (6a, 8a) defined by the two first adjacent patterns (2a, 2b) of the group associated therewith and level with the deepest region of said cavities.

3. Bubble memory according to claim 1, characterized in that first patterns (2, 30a) have identical shapes and sizes.

4. Bubble memory according to any one of the claims 1 to 3, characterized in that the distance (1) separating the deepest regions of the two cavities (6, 8) defined between the first adjacent patterns (2) of a first group is between 2 and 20 µm for approximately 2 µm bubbles (12).

5. Bubble memory according to any one of the claims 1 to 4, also comprising minor loops (20) used for the storage of bubbles (12), which are juxtapozed and each having two ends (48, 60), said minor loops (20) being formed from contiguous, unimplanted propagation patterns (22), which are called second patterns, at least one major loop (24, 56, 58) serving as an access loop to the minor loops (20), positioned perpendicular to said minor loops, said major loop (24, 56, 58) being formed by unimplanted, contiguous propagation patterns (26, 63, 65), called third patterns, and means (68, 72, 78) for detecting and producing bubbles (12) on the major loop, characterized in that each minor loop (20) being folded in such a way that it defines, at one of its ends (48), two separate portions (52, 50) which are juxtaposed, the first portion (52) being used for injecting bubbles (12) into said minor loop (20) and the second portion (50) is used for the extraction of bubbles (12) from said minor loop (20), and in that each minor loop (20) is associated with a group of first patterns (28) used for the transfer of bubbles (12) from the corresponding minor loop (20) to the major loop (24, 56, 58) and vice versa, said groups of first patterns (28) having at one of their ends (36) two separate branches, a first branch (46) being used for the injection of bubbles (12) into the corresponding minor loop (20) and a second branch (44) is used for the extraction of bubbles (12) from the corresponding minor loop (20, said branches, formed from contiguous, aligned and unimplanted propagation patterns (30b), called fourth patterns, being juxtaposed in such a way that the end (46a) of the first branch (46) faces the end (52a) of the first portion (52) of the corresponding minor loop (20) and the end (44a) of the second branch (44) faces end (50a) of the second portion (50) of the corresponding minor loop (20), end (50a) of the second branch (50) being provided with a unidirectional transfer gate (54) for the transfer of bubbles (12) from minor loop (20) to the group of associated patterns (28).

6. Bubble memory according to claim 5, characterized in that the fourth end pattern (30b) of said first branch (46) and the second end pattern (22) of said first portion (52) of the minor loop (20), which face one another, are aligned, said alignment forming an angle close to 30° with the crystallographic axis ($\overline{1}\,\overline{1}\,2$) of the first magnetic layer (38).

7. Bubble memory according to one of the claims 5 and 6, characterized in that the unidirectional transfer gates (54) are formed by U-shaped electrical conductors.

8. Bubble memory according to any one of the claims 5 to 7, characterized in that the two portions (50, 52) of the minor loops (20) have a length such that a bubble (12), obtained by the duplication of a mother bubble, returns to the minor loop (20) in the place occupied by the mother bubble.

9. Bubble memory according to any one of the claims 5 to 8, characterized in that the groups of first patterns (28) have at their other end (31) a bidirectional transfer gate 32 for transferring bubbles (12) from the major loop (24) to said groups of patterns (28) and vice versa.

10. Bubble memory according to any one of the claims 5 to 8, comprising two major loops (56, 58), the first (58) facing the detection means (72) of bubbles (12) and the second (56) facing means making it possible to produce bubbles (68, 78), characterized in that the groups of first bubbles (28) being linked, level with the other end (62) thereof, with the first major loop (58), the latter having openings (66) made in the third unimplanted pattern (65) forming the same, making it possible to transfer bubbles (12) from the group of first patterns (28) to said major loop and in that the other end (60) of the minor loops (20) has a transfer gate (64) permitting the transfer of bubbles (12) from said minor loops (20) the second major loop (56) and vice versa.

11. Bubble memory according to any one of the claims 5 to 10, characterized in that the means (78) for providing bubbles (12) comprise a group of contiguous, unimplanted propagation patterns (79), called fifth patterns, shaped in such a way that two cavities (80, 82) are defined between two adjacent patterns (79), part of said patterns (79) being located so as to form a closed loop (84), whilst the other part (86) constitutes a propagation path for the bubbles produced and an electrical conductor (88), called the second conductor, makes it possible to duplicate bubbles (12), when at least one current pulse is applied thereto, positioned perpendicular to the crystallographic axis ($\overline{1}\,\overline{1}\,2$) of the first magnetic layer (87), said group of first patterns being traversed by said second conductor level with the part in the form of a closed loop (84).

12. Bubble memory according to claim 11, characterized in that the first magnetic layer (87) has three crystallographic axes, so that the closed loop (84) has the symmetry of order three of said magnetic layer.

13. Bubble memory according to any one of the claims 11 and 12, characterized in that the second electrical conductor (88) has an axis of symmetry (90) and is positioned in such a way that its axis of symmetry (90) passes through the two cavities (80a, 82a) defined by two adjacent fifth patterns (79a, 79b) and level with the deepest region of said cavities.

14. Bubble memory according to any one of the claims 11 to 13, characterized in that the fifth patterns (79) have identical shapes and sizes.

15. Bubble memory according to any one of the claims 11 to 14, characterized in that the fifth patterns (79) are in the form of circles, triangles or hexagons.

16. Bubble memory according to any one of the claims 11 to 15, characterized in that the fifth adjacent patterns (79a, 79b), at the location of the second electrical conductor (88), in each case have an implanted region (92), said regions (92) being arranged symmetrically with respect to the axis of symmetry (90) of the second conductor (88).

17. Bubble memory according to any one of the claims 11 to 16, characterized in that the distance (d) separating the deepest regions of the two cavities (80a, 82a) defined between two fifth adjacent patterns (79a, 79b) is between 2 and 20 µm for approximately 2 µm bubbles.

18. Bubble memory according to any one of the claims 1 to 17, characterized in that the current pulse has a single amplitude level.

19. Bubble memory according to any one of the claims 1 to 17, characterized in that the current pulse has several amplitude levels of the same sign.

20. Bubble memory according to any one of the claims 1 to 17, characterized in that the current pulse has several amplitude levels of opposite signs.

21. Application of the bubble memory according to any one of the claims 1 to 20 to bit-by-bit duplication, duplication being carried out by energizing the electrical conductors used for the duplication by successive current pulses.

22. Application of the bubble memory according to any one of the claims 1 to 20 to duplication by bit blocks.

FIG.1

FIG.2

FIG.3

FIG.4

# FIG. 5